# EUROPEAN PATENT APPLICATION

(11) **EP 2 367 276 A2**
(43) Date of publication of application: **21.09.2011**
(21) Application number: 11153141.4
(22) Date of filing: 03.02.2011
(51) Int. Cl.: H02M 7/00

(54) **Power conditioner device and module substrate structure using the same**

(30) Priority: 15.03.2010 JP 2010057883
(71) Applicant: Omron Co., Ltd., Kyoto-shi, Kyoto 600-8530 (JP)
(72) Inventor: Takashiro, Hiroto, Kyoto-shi, Kyoto 600-8530 (JP); Tsubota, Yasuhiro, Kyoto-shi, Kyoto 600-8530 (JP); Katayama, Kensei, Kyoto-shi, Kyoto 600-8530 (JP)
(74) Representative: Wilhelms · Kilian & Partner Patentanwälte

(57) **Abstract**

This invention enhances the maintenance when the individual electronic component fails and realizes low cost maintenance. When raising the DC power supplied from a solar cell or a fuel cell by means of a DC/DC converter circuit (30) and converting to the AC power by means of an inverter circuit (40), an electronic circuit such as the DC/DC converter circuit (30) and the inverter circuit (40) or a CPU for controlling the operation of the circuits are accommodated in a case body to supply the AC power to a general load, the DC/DC converter circuit (30) and the inverter circuit (40) are mounted on a DC/DC converter circuit mounting substrate (31) and an inverter circuit mounting substrate (41), which are configured as separate bodies, for modularization.

## Description

### BACKGROUND OF THE INVENTION

### 1. TECHNICAL FIELD

The present invention relates to a power conditioner for raising a DC (Direct Current) power supplies from a solar cell, fuel cell and the like and then converting to an AC (Alternating Current) power, and supplying the AC power to a general load, and a module substrate structure used in the same.

### 2. RELATED ART

This type of power conditioner device is configured by a DC/DC converter circuit for raising the DC power supplied from a solar cell and a fuel cell, an inverter circuit for rectifying the DC power supplied from the DC/DC converter circuit in a reactor and converting to the AC power, a CPU for controlling the DC/DC converter circuit and the inverter circuit, or the like.

The DC/DC converter circuit and the inverter circuit are configured to include a great number of electronic components such as a switching element and a diode along with the CPU and the like, where the electronic components such as the switching element, the diode, and the reactor are configured by being mounted on a single substrate in the related art (see e.g., Japanese Unexamined Patent Publication No. 2006-54215).

The power conditioner device, however, is configured by mounting each electronic component on the single printed substrate, and thus it is very difficult to change each defected electronic component for maintenance if each electronic component is individually defected, and it is necessary to change the defected electronic component to a new printed substrate configured with all new electronic components mounted thereon, in which case the old printed substrate on which normal electronic components are still mounted is disposed, so that the maintenance cost increases, and the global environment may be affected.

Furthermore, the inverter circuit and the DC/DC converter circuit emit a very high temperature as they are configured using the switching element, which may adversely affect the operation of the CPU and the like.

### SUMMARY

An object of the present invention is to provide a power conditioner device that firstly enhances maintenance when the individual electronic component is defected and realizes maintenance at low cost and contributes to protecting global environment, and secondly efficiently cools the high heat emitted by the switching element or the reactor to prevent other electronic components from being affected, and a module substrate structure using the same.

In accordance with one aspect of the present invention, a power conditioner device according to the present invention is a module substrate structure used in a power conditioner device for raising a DC power by a DC/DC converter circuit and then converting to an AC power by an inverter circuit, and being configured by accommodating an electronic circuit such as the DC/DC converter circuit and the inverter circuit or a CPU for controlling the operation of the circuits in a case body, wherein the DC/DC converter circuit and the inverter circuit are respectively mounted on a DC/DC converter circuit mounting substrate and an inverter circuit mounting substrate, which are configured as separate bodies, for modularization.

According to the present invention, the DC.DC converter circuit and the inverter circuit are respectively mounted on the DC/DC converter circuit mounting substrate and the inverter circuit mounting substrate, which are configured as separate bodies, for modularization, so that when the individual electronic component fails, the maintenance task can be realized by simply changing the circuit mounting substrate that mounts one circuit to a new one and the maintenance cost can be reduced by continuously using the other circuit mounting substrate as it is, and furthermore, contribute to protection of global environment with the changing range to a new electronic component limited to a minimum since the DC/DC converter circuit and the inverter circuit are respectively mounted on the DC/DC converter circuit mounting substrate and the inverter circuit mounting substrate, which are configured as separate bodies.

In the power conditioner device according to the aspect of the present invention, the inverter circuit is configured with two by-phase inverter circuits to output a single-phase AC, and each of the by-phase inverter circuits is mounted on each of by-phase inverter circuit mounting substrates configured as a separate body for modularization,

According to the present invention having the above configuration, the two by-phase inverter circuits are respectively mounted on the by-phase inverter mounting substrate configured as separate bodies, so that when the electronic component configuring one by-phase inverter circuit fails, the maintenance task can be realized and the maintenance cost can be reduced by simply changing the inverter circuit mounting substrate that mounts the failed electronic component to a new one, the electronic component that is not yet failed is prevented from being discarded while minimizing the exchange range with a new electronic component thereby contributing to protection of global environment.

In the power conditioner device according to another aspect of the present invention, the inverter circuit is configured with three by-phase inverter circuits to output a three-phase AC, and each of the by-phase inverter circuits is mounted on each of by-phase inverter circuit mounting substrates configured as a separate body for modularization.

According to the present invention having the above configuration, the three by-phase inverter circuits are respectively mounted on the by-phase inverter mounting substrate configured as separate bodies, so that when the electronic component configuring one by-phase inverter circuit fails, the maintenance task can be realized and the maintenance cost can be reduced by simply changing the inverter circuit mounting substrate that mounts the failed electronic component to a new one, the electronic component that is not yet failed is prevented from being discarded by minimizing the exchange range with a new electronic component thereby contributing to protection of global environment.

In the power conditioner device according to the another one aspect, a plurality of inverter circuit switching elements is mounted in parallel on each of the by-phase inverter circuit mounting substrates to respectively configure each of the by-phase inverter circuits to configure an inverter circuit switching element group, and a plurality of DC/DC converter circuit switching elements configuring the DC/DC converter circuit is mounted in parallel on the DC/DC converter circuit mounting substrate to configure a DC/DC circuit switching element group; a DC/DC converter circuit switching element group of the DC/DC converter circuit and a first inverter circuit switching element group configuring a first by-phase inverter circuit of the three by-phase inverter circuits are arranged to face each other, and a second inverter circuit switching element group configuring a second by-phase inverter circuit and a third inverter circuit switching element group configuring a third by-phase inverter circuit of the three by-phase inverter circuits are arranged to face each other in the case; and the DC/DC converter circuit switching element group and the first inverter circuit switching element group, and the second inverter circuit switching element group and the third inverter circuit switching element group are arranged to face each other in the case.

According to the present invention having the above configuration, each inverter circuit switching element group configuring each of the by-phase inverter circuits and the DC/DC circuit switching element group configuring the DC/DC converter circuit can be gathered in a cluster in the case, so that the high heat generated by each switching element can be efficiently cooled so as not to affect the other electronic components.

In the power conditioner device according to another one aspect of the present invention, the DC/DC converter circuit switching element group and the first inverter circuit switching element group, and the second inverter circuit switching element group and the third inverter circuit switching element group are spaced apart from each other on a surface side of the base member to form a space, a reactor being arranged on the surface side of the base member in the space.

The present invention having the above configuration has the reactor arranged in the space formed between the DC/DC converter circuit switching element group and the first inverter circuit switching element group, and the second inverter circuit switching element group and the third inverter circuit switching element group on the surface of the base member, so that the influence from the high heat generated by each switching element in each of the by-phase inverter circuits by the reactor can be reduced thereby individually cooling the same, and the cooling function of the device can be efficiently achieved.

In the power conditioner device according to another aspect of the present invention, a first main heat sink is installed on a rear surface side of the base member so that the DC/DC converter circuit switching element group and the first inverter circuit switching element group face each other, and a second main heat sink is installed so that the second inverter circuit switching element group and the third inverter circuit switching element group face each other.

The present invention having the above configuration has each of switching element groups individually cooled by the first main heat sink and the second main heat sink, thereby exhibiting an efficient cooling function as a result.

The module substrate structure used in the power conditioner device according to the present invention relates to a module substrate structure used in a power conditioner for raising a DC power by a DC/DC converter circuit and then converting to an AC power by an inverter circuit, and being configured by accommodating an electronic circuit such as the DC/DC converter circuit and the inverter circuit or a CPU for controlling the operation of the circuits in a case body, wherein the DC/DC converter circuit and the inverter circuit are respectively mounted on a DC/DC converter circuit mounting substrate and an inverter circuit mounting substrate, which are configured as separate bodies, for modularization.

According to the present invention, the DC/DC converter circuit and the inverter circuit are respectively mounted on the DC/DC converter circuit mounting substrate and the inverter circuit mounting substrate, which are configured as separate bodies, for modularization, so that when the individual electronic component fails, the maintenance task can be realized by simply changing the circuit mounting substrate that mounts one circuit to a new one and the maintenance cost can be reduced by continuously using the other circuit mounting substrate as it is, and furthermore, contribute to protection of global environment with the changing range to a new electronic component limited to a minimum since the DC/DC converter circuit and the inverter circuit are respectively mounted on the DC/DC converter circuit mounting substrate and the inverter circuit mounting substrate, which are configured as separate bodies.

In the power conditioner device according to another aspect of the present invention and the module substrate structure used in the power conditioner, the inverter circuit is configured with two by-phase inverter circuits to output a single-phase AC, and each of the by-phase inverter circuits is mounted on each of by-phase inverter circuit mounting substrates configured as a separate body for modularization.

According to the present invention having the above configuration, the two by-phase inverter circuits are respectively mounted on the by-phase inverter mounting substrate configured as separate bodies, so that when the electronic component configuring one by-phase inverter circuit fails, the maintenance task can be realized and the maintenance cost can be reduced by simply changing the inverter circuit mounting substrate that mounts the failed electronic component to a new one, the electronic component that is not yet failed is prevented from being discarded while minimizing the exchange range with a new electronic component thereby contributing to protection of global environment.

In the power conditioner device according to another aspect of the present invention and the module substrate structure used in the power conditioner device, the inverter circuit is configured with three by-phase inverter circuits to output a three-phase AC, and each of the by-phase inverter circuits is mounted on each of by-phase inverter circuit mounting substrates configured as a separate body for modularization.

According to the present invention having the above configuration, the three by-phase inverter circuits are respectively mounted on the by-phase inverter mounting substrate configured as separate bodies, so that when the electronic component configuring one by-phase inverter circuit fails, the maintenance task can be realized and the maintenance cost can be reduced by simply changing the inverter circuit mounting substrate that mounts the failed electronic component to a new one, the electronic component that is not yet failed is prevented from being discarded by minimizing the exchange range with a new electronic component thereby contributing to protection of global environment.

In the power conditioner device according to another aspect of the present invention, cooling fans for forcibly supplying cooled air into the air cooling ducts are installed at the most upstream of the air cooling ducts.

According to the present invention having the above configuration, the cooling fan is installed on the most upstream side of each of the air cooling ducts, and thus the cooling fan can reduce the influence of the high heat generated by each of switching element groups and the lifespan of the cooling fan can be extended

In the power conditioner device according to another aspect of the present invention, the CPU is arranged so as to be positioned on the upstream side site of the air cooling ducts in the base member.

According to the present invention having the above configuration, the CPU that is subjected to heat is installed in the case so as to be positioned on the upstream side of the air cooling duct to constantly exhibit the normal control function without being influenced by the high heat emitted by each of switching element groups and the reactor.

The configuration configured as above has the DC/DC converter circuit and the inverter circuit that are respectively mounted on the DC/DC converter circuit mounting substrate and the inverter circuit mounting substrate, which are configured as separate bodies, for modularization, so that when the individual electronic component fails, the maintenance task can be realized by simply changing the circuit mounting substrate that mounts one circuit to a new one and the maintenance cost can be reduced by continuously using the other circuit mounting substrate as it is, and furthermore, contribute to protection of global environment with the changing range to a new electronic component limited to a minimum since the DC/DC converter circuit and the inverter circuit are respectively mounted on the DC/DC converter circuit mounting substrate and the inverter circuit mounting substrate, which are configured as separate bodies.

The present invention configured as above is configured such that each inverter circuit switching element group configuring each of the by-phase inverter circuits and the DC/DC circuit switching element group configuring the DC/DC converter circuit can be gathered in a cluster in the case, so that the high heat generated by each switching element can be efficiently cooled so as not to affect the other electronic components.

### BRIEF DESCRIPTION OF THE DRAWINGS

Fig. 1 is a perspective view of a power conditioner device adopting an example according to the present invention seen from the upper side of the front surface;
Fig. 2 is a perspective view of the power conditioner device adopting the example according to the present invention seen from the lower side of the rear surface;
Fig. 3 is an exploded perspective view of the power conditioner device adopting the example according to the present invention;
Fig. 4 is a plan view of a base member shown in Fig. 3;
Fig. 5 is a plan view showing a state in which electronic components in the power conditioner device adopting the example according to the present invention are arranged on the base member shown in Fig. 3;
Fig. 6 is a schematic perspective view showing a state in which a DC/DC converter circuit configuring the power conditioner device adopting the example according to the present invention is mounted on a DC/DC converter circuit mounting substrate;
Fig. 7 is a schematic perspective view showing a state in which an inverter circuit configuring the power conditioner device adopting the example according to the present invention is mounted on an inverter circuit mounting substrate;
Fig. 8 is a perspective view of an attachment lock tool for attaching the switching element configuring the inverter circuit of the power conditioner device according to the example of the present invention to the auxiliary heat sink;
Fig. 9 is a view showing the state in which the switching element is attached to the auxiliary heat sink using the attachment lock tool shown in Fig. 8 seen from the side surface side of the auxiliary heat sink; and
Fig. 10 is a cross-sectional view taken along line A-A.

### DETAILED DESCRIPTION

A power conditioner device adopting the examples according to the present invention and a module substrate structure used in the device will be hereinafter described using the drawings.

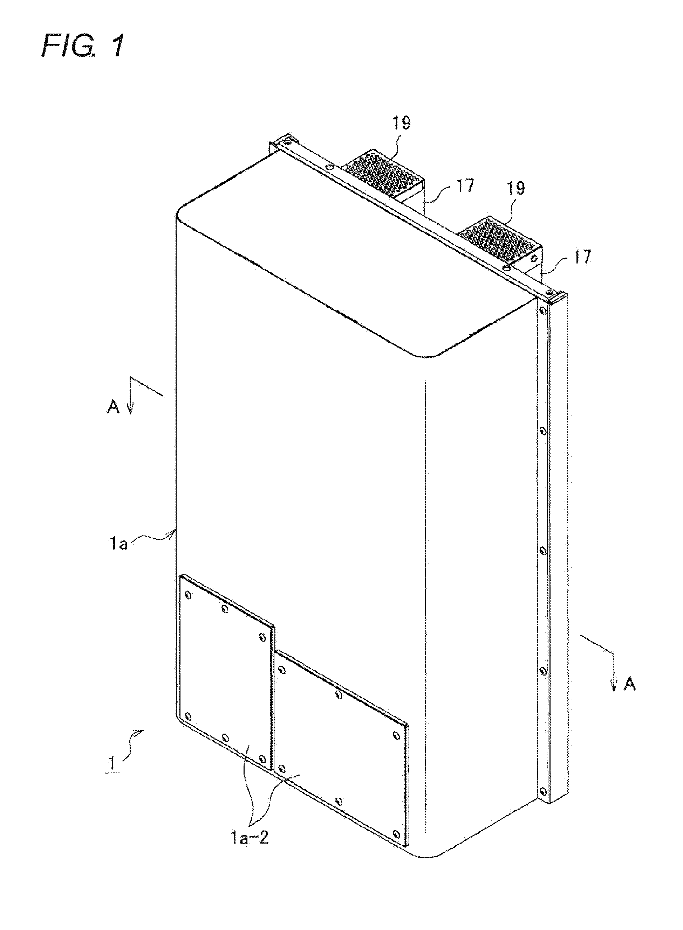

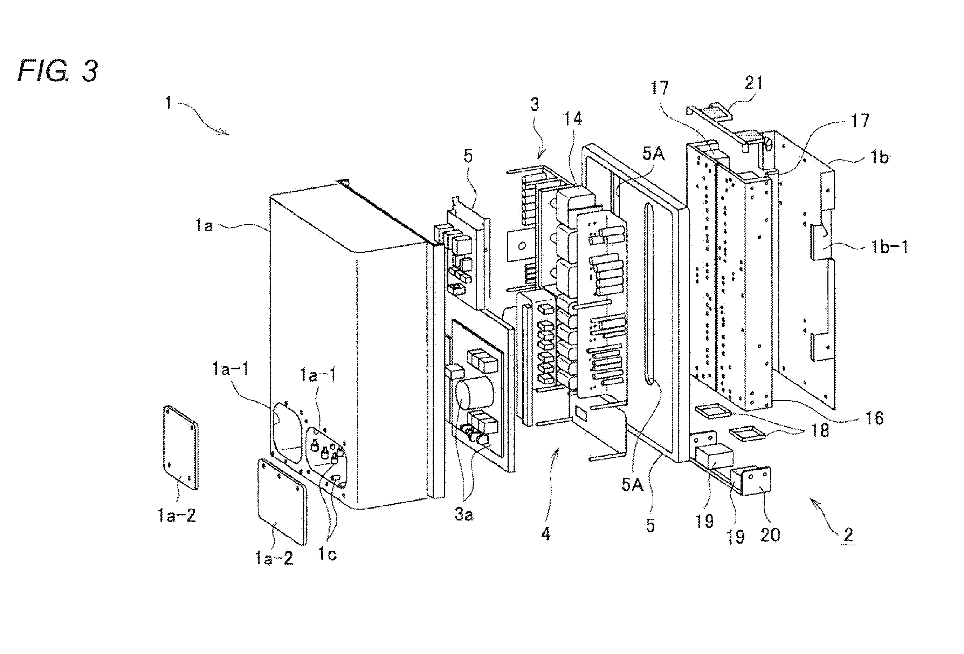

In Fig. 1 to Fig. 3, a case 1 of the power conditioner device for raising the DC power supplied from the solar cell, the fuel cell and the like, and then converting to the AC power is a rectangular accommodating box body made of metal that is flat in the front and back direction and that is long in the up and down direction in front view, and is configured so that the width in the left and right direction has a dimension that can be installed at an existing installing location in turn with a case main body (not shown) for handling small current to handle large current of about 10 ampere, where the case 1 is configured by a housing 1a having an accommodating space for accommodating electronic components and the like, to be described later and having the rear surface side opened, and a rear surface lid body 1b for closing the opening of the housing 1a, the rear surface lid body 1b being fixed to the housing 1a by engaging an engagement piece 1b-1 to an engagement portion (not shown) on the housing 1a side while closing the opening of the housing 1a.

A pair of small openings 1a-1 is formed at the site closer to the upper side of the front surface of the housing 1a to exhibit a connector 1c, and the like accommodated in the housing 1 a to the outside (see Fig, 3), the small opening 1a-1 being blocked by fixing a cover body 1a-2 to the housing 1 a with a thread and the like while interposing a seal material (not shown) therebetween.

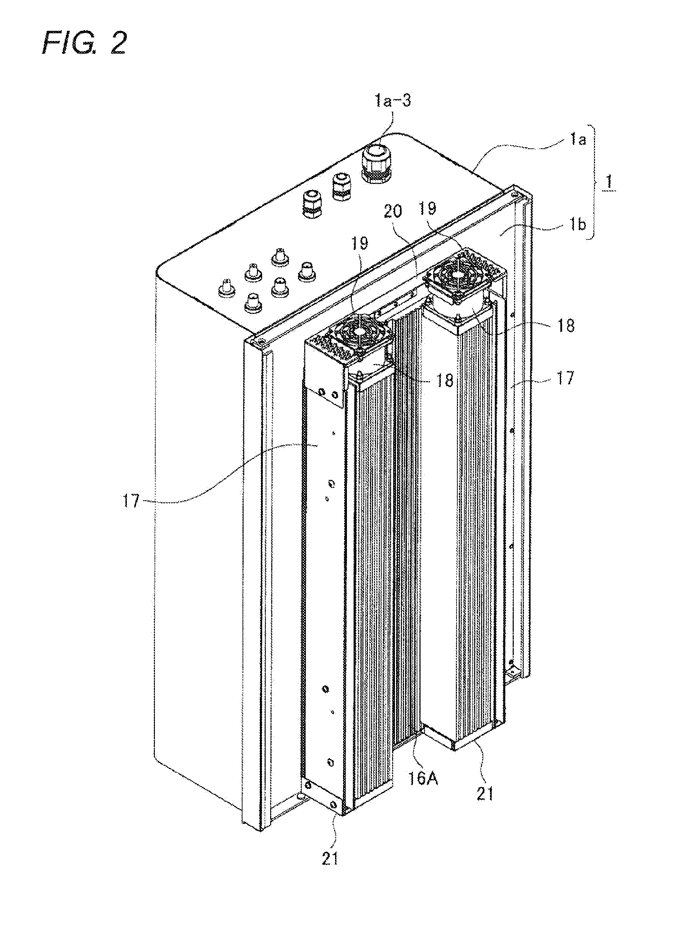

As shown in Fig. 2, a plurality of harness clamp tools 1a-3 for pulling out the harness arranged in the housing 1a to the outside is installed at the lower surface of the housing 1a.

A cooling device 2, to be described in detail later, is installed on the rear surface lid body 1b.

The case 1 is configured such that a control substrate 3 mounted with a plurality of electronic components 3a, a power module substrate 4 arranged with a power module 10, a base member 5 for installing the power module substrate 4, and the cooling device 2 are accommodated in order from the front surface side to the rear surface side of the housing 1 a, and then the opening is closed with the rear surface lid body 1b.

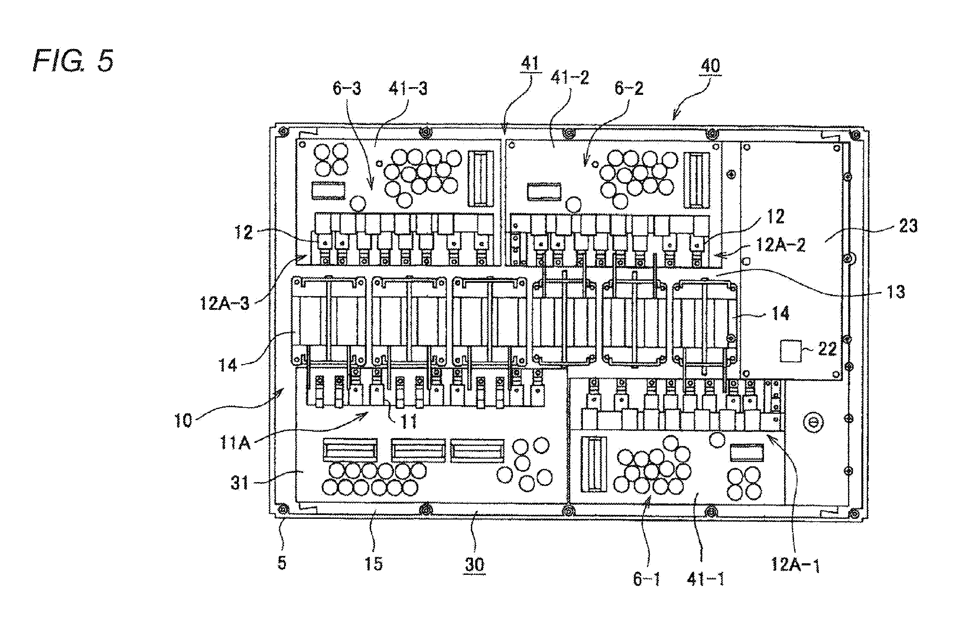

As shown in Fig. 5, the power module substrate 4 is configured to include a DC/DC converter circuit mounting substrate 31, an inverter circuit mounting substrate 41, and a CPU mounting substrate 23, which are configured as separate bodies from each other, where the inverter circuit mounting substrate 41 is configured to include a first inverter circuit mounting substrate 41-1, a second inverter circuit mounting substrate 41-2, and a third inverter circuit mounting substrate 41-3 to mount three by-phase inverter circuits 6-1 , 6-2, and 6-3 for outputting three phase alternating currents in the present device.

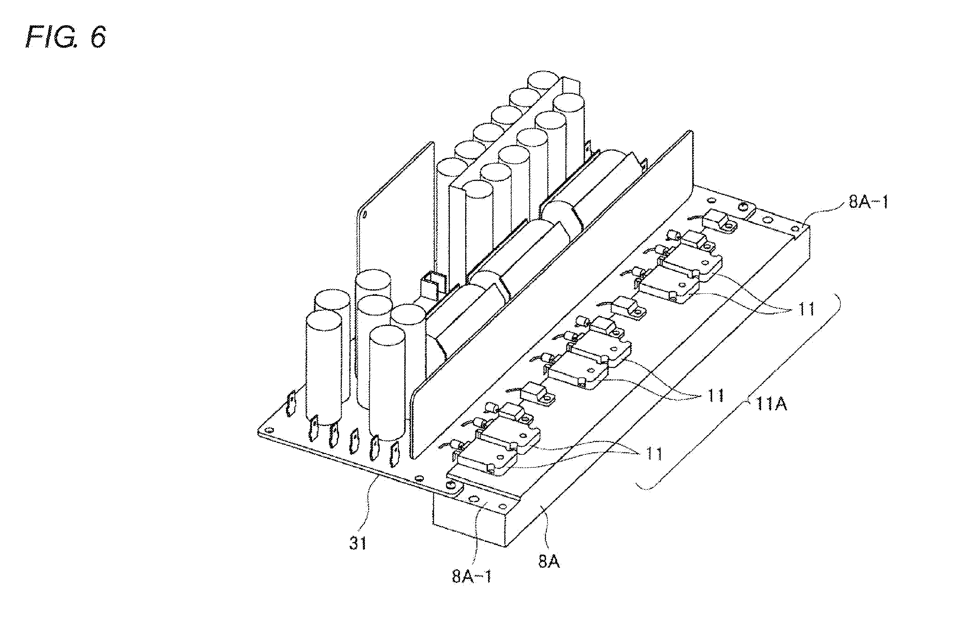

As shown in Fig. 6, the DC/DC converter circuit mounting substrate 31 is mounted with a plurality of DC/DC converter circuit switching elements 11 in addition to the electronic components such as a capacitor and a thermistor, and also installs the DC/DC converter circuit switching elements 11 directly to an auxiliary heat sink 8A made of aluminum bar material for modularization of the DC/DC converter circuit 30.

The auxiliary heat sink 8A attached with the DC/DC converter circuit switching elements 11 is joined to an opposing substrate surface on the opposite side with respect to a substrate surface mounted with the DC/DC converter circuit switching elements 11 in the DC/DC converter circuit mounting substrate 31, and fixed and installed thereto with a screw and the like. In this case, a step portion 8A-1 is formed in the auxiliary heat sink 8A so that the substrate surface mounted with the DC/DC converter circuit switching element 11 in the inverter circuit mounting substrate 41 does not project out towards the installing surface side in the auxiliary heat sink 8A where the DC/DC converter circuit switching elements 11 are installed.

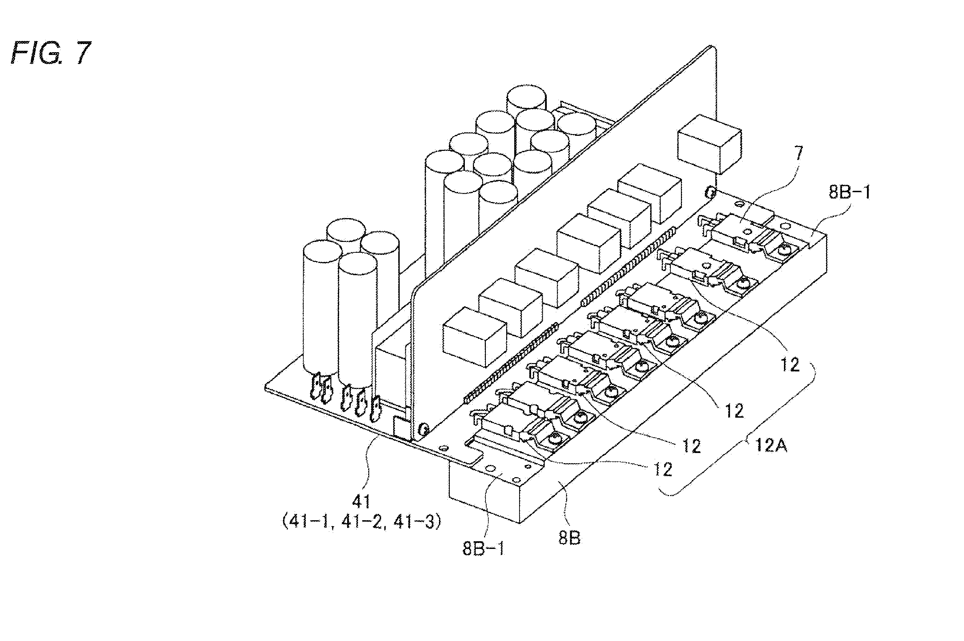

As shown in Fig. 7, the first inverter circuit mounting substrate 41-1, the second inverter circuit mounting substrate 41-2, and the third inverter circuit mounting substrate 41-3, which are configured as separate bodies from each other, configuring the inverter circuit mounting substrate 41 are mounted with a plurality of inverter circuit switching elements 12 in addition to the electronic components such as the capacitor and the thermistor similar to the DC/DC converter circuit mounting substrate 31 described above, and such switching elements are directly installed to an auxiliary heat sink 8B made of aluminum bar material for modularization of the inverter circuit 40.

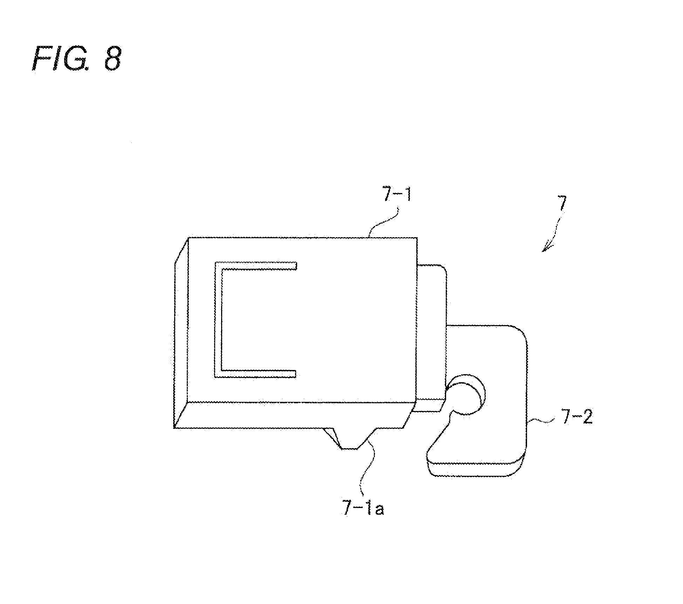

The direct installation of the inverter circuit switching element 12 to the auxiliary heat sink 8B is carried out using an attachment lock tool 7 shown in Fig. 8. In other words, the attachment lock tool 7 is configured by integrally forming a substantially flat plate shaped switching element side fixed piece 7-1 and an auxiliary heat sink side lock piece 7-2.

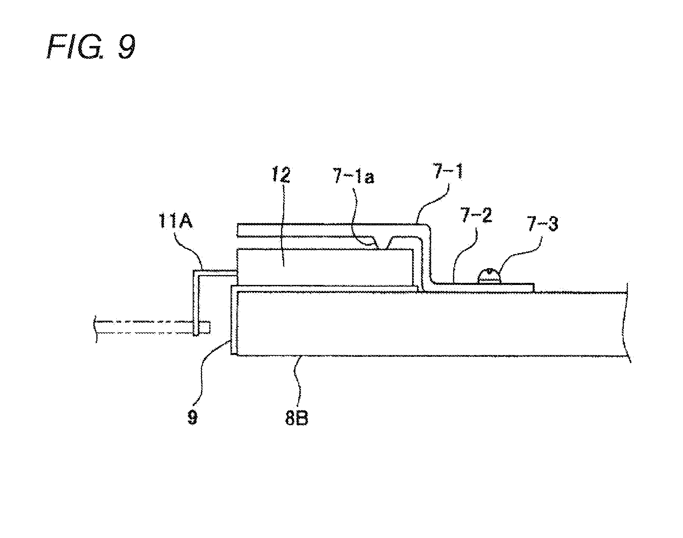

As shown in Fig. 9, the inverter circuit switching element 12 is mounted while interposing a heat dissipating sheet 9 having electrical insulating property on the auxiliary heat sink 8B, and then the auxiliary heat sink side lock piece 7-2 is locked to a screw 7-3 screwed into the auxiliary heat sink 8B so that a projection 7-1 a of the switching element fixed piece 7-1 pushes and fixes the inverter circuit switching element 12 toward the auxiliary heat sink 8B side by elastic force.

In this case, the inverter circuit switching element 12 is installed with adhesiveness with respect to the auxiliary heat sink 8B by interposing the heat dissipation sheet 9 therebetween. Furthermore, the heat dissipation sheet 9 is extended and interposed between the auxiliary heat sink 8B and the terminal 11a of the DC/DC converter circuit switching element 11 to provide an insulating distance between the auxiliary heat sink 8B and the terminal 11a of the inverter circuit switching element 12, as shown in Fig. 9. The heat dissipating sheet 9 is joined to the auxiliary heat sink 8B with an adhesive, and the like.

The auxiliary heat sink 8B including the inverter circuit switching element 12 is joined to the opposing substrate surface on the opposite side with respect to the substrate surface mounted with the inverter circuit switching element 12 in the inverter circuit mounting substrate 41, and fixed and installed with the screw and the like. In this case, a step portion 8B-1 is formed in the auxiliary heat sink 8B so that the substrate surface mounted with the inverter circuit switching element 12 in the inverter circuit mounting substrate 41 does not project out towards the installing surface side in the auxiliary heat sink 8B where the inverter circuit switching elements 12 are installed (see Fig. 7).

When mounting a plurality of DC/DC converter circuit switching elements 11 on the DC/DC converter circuit mounting substrate 31, the plurality of DC/DC converter circuit switching elements 11 are mounted in parallel in a straight line on one side end of the DC/DC converter circuit mounting substrate 31 to configure a DC/DC circuit switching element group 11A.

When mounting the plurality of inverter circuit switching elements 12 on each of the first inverter circuit mounting substrate 41-1, the second inverter circuit mounting substrate 41-2, and the third inverter circuit mounting substrate 41-3, the plurality of inverter circuit switching elements 12 are mounted in parallel in a straight line on one side end of the first inverter circuit mounting substrate 41-1, the second inverter circuit mounting substrate 41-2, and the third inverter circuit mounting substrate 41-3, respectively to configure an inverter circuit switching element group 12A, as shown in Fig. 7.

The DC/DC converter circuit mounting substrate 31, the first inverter circuit mounting substrate 41-1, the second inverter circuit mounting substrate 41-2, and the third inverter circuit mounting substrate 41-3 are all attached to the base member 5 with the screw and the like. The arrangement of the DC/DC converter circuit mounting substrate 31, the first inverter circuit mounting substrate 41-1, the second inverter circuit mounting substrate 41-2, and the third inverter circuit mounting substrate 41-3 to the base member 5 includes the steps of arranging the first inverter circuit switching element group 12A-1 configuring the first by-phase inverter circuit 6-1 and the DC/DC converter circuit switching element group 11A configuring the DC/DC converter circuit on the base member 5 so as to face each other, arranging the second inverter circuit switching element group 12A-2 configuring the second by-phase inverter circuit 6-2 and the third inverter circuit switching element group 12A-3 configuring the third by-phase inverter circuit 6-3 so as to face each other, and furthermore, arranging the first inverter circuit switching element group 12A-1 and the DC/DC converter circuit switching element group 11A of the DC/DC converter circuit, and the second inverter circuit switching element group 12A-2 and the third inverter circuit switching element group 12A-3 so as to be face each other at substantially a central part of the surface of the base member 5 in the case 1.

A space 13 is formed between the DC/DC converter circuit switching element group 11A and the first inverter circuit switching element group 12A-1, and the second inverter circuit switching element group 12A-2 and the third inverter circuit switching element group 12A-3 at substantially the central part of the base member 5, and a plurality of reactors 14 is arranged on the surface of the base member 5 at the space 13.

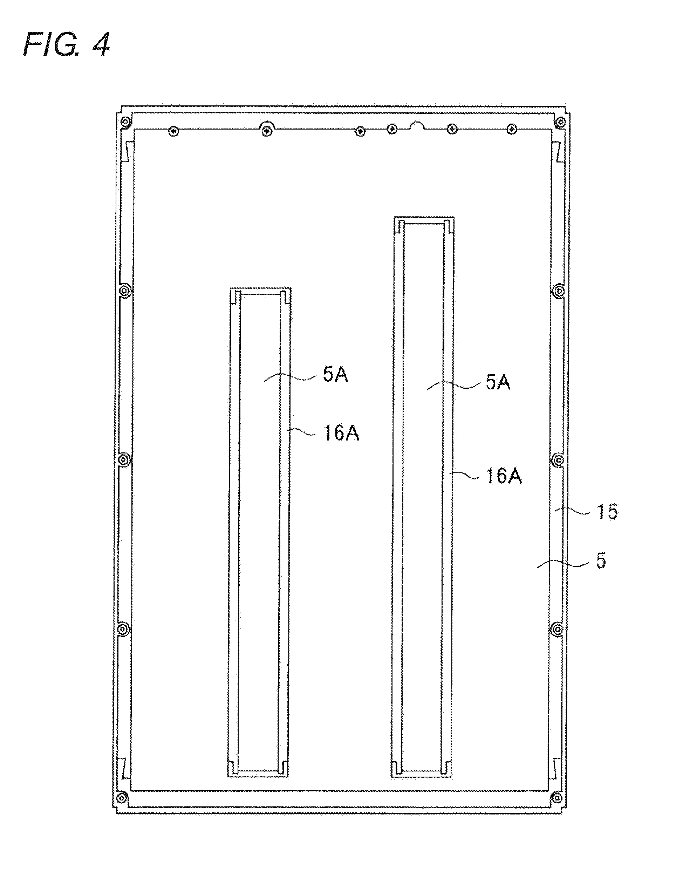

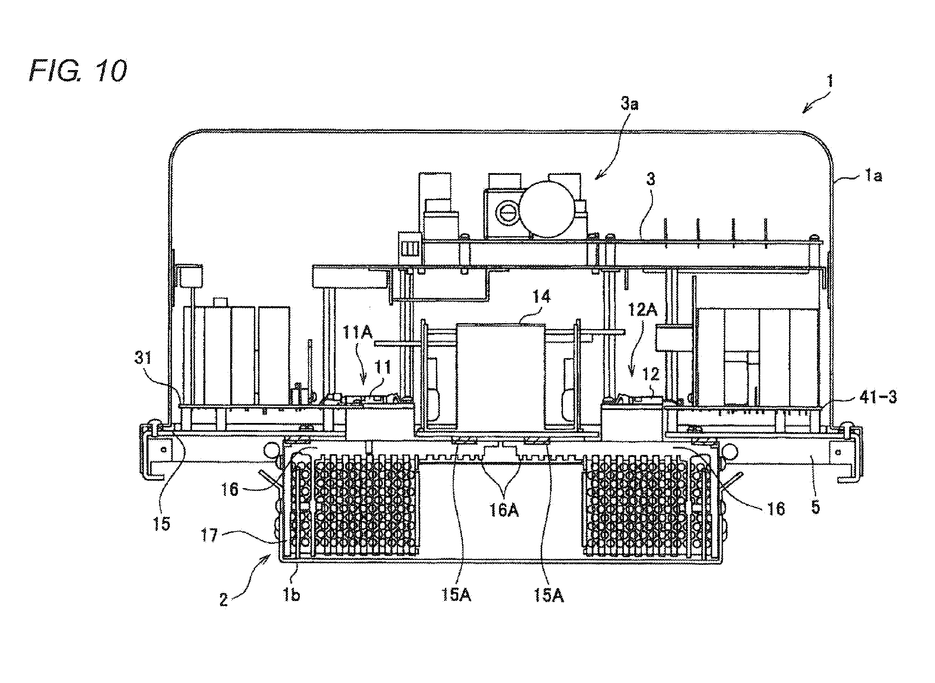

As shown in Fig. 4, the base member 5 has a ring-shaped packing 15 arranged to surround the outer peripheral end, the ring-shaped packing 15 exhibiting adhesiveness between the base member 5 and the housing 1a so that rainwater and the like do not intrude into the case 1, as shown in Fig. 10.

A through-hole 5A is formed at the sites facing the auxiliary heat sinks 8A, 8B in the base member 5, and the auxiliary heat sinks 8A, 8B are fitted to the respective through-holes 5A.

Furthermore, first and second main heat sinks 16, 16, which are configured as separate bodies made of aluminum material and the like from each other, are joined and installed on the rear surface side of the base member 5 so as to face each DC/DC converter circuit switching element group 11A, 12B mounted on the DC/DC converter circuit mounting substrate 31 and the inverter circuit mounting substrate 41.

The first and second main heat sinks 16, 16 have a heat dissipating surface of a convex-concave form formed on the opposing surface facing the installing surface of the base member 5, and each side of the first and second main heat sinks 16, 16 is extended in a region having a slight gap with each other on the space 13 side at the central part of the base member 5, so that an air cooling fins 16A, 16A for cooling the reactor are formed, the air cooling fins 16A, 166A for cooling the reactor being configured to face the reactor 14 to cool the reactor 14.

Furthermore, air cooling ducts 17, 17 for introducing cooled air for mainly cooling the switching element groups 11A, 12A are installed at the rear surface side of the first and second main heat sinks 16, 16 so as to face each auxiliary heat sink 8A, 8B.

Cooling fans 19, 19 for forcibly supplying cooled air into the air cooling ducts 17, 17 with half-ducts 18, 18 interposed therebetween are installed at the most upstream side (lower part side in the installation state of the case 1) of the air cooling ducts 17, 17. The cooling fans 8, 8 respectively form a sub-assy by an attachment member 20 to the air cooling ducts 17m 17. The half-ducts 18, 18 ensure an insulating distance between the first and second main heat sinks 16, 16 in the cooling fans 8, 8 and are configured from an insulating material

A top surface cover body 21 having an opening of a mesh form being blocked is attached to the top surface (upper part side in the installation state of the case 1) that is the most downstream side of the air cooling ducts 17, 17, so that bugs, dust and the like are prevented from intruding into the air cooling ducts 17, 17.

A ring-shaped packing 15A is interposed between the air cooling ducts 17, 17 and the base member 5. The ring-shaped packing 15A is installed to surround the through-hole 5A.

Furthermore, a CPU mounting substrate 23 installed with the CPU 22 is arranged so as to be positioned on the upstream side site of the air cooling ducts 17, 17 in the base member 5.

In the power conditioner device according to the example of the present invention having the configuration described above, the DC/DC converter circuit 30 and the inverter circuit 40 are respectively mounted on the DC/DC converter circuit mounting substrate 31 and the inverter circuit mounting substrate 41, which are configured as separate bodies, for modularization, so that when the individual electronic component fails, the maintenance task can be realized by simply changing the circuit mounting substrate that mounts one circuit to a new one and the maintenance cost can be reduced by continuously using the other circuit mounting substrate c as it is, and furthermore, contribute to protection of global environment with the changing range to a new electronic component limited to a minimum since the DC/DC converter circuit 30 and the inverter circuit 40 are respectively mounted on the DC/DC converter circuit mounting substrate 31 and the inverter circuit mounting substrate 41, which are configured as separate bodies.

In the above configuration, the three by-phase inverter circuits 6-1, 6-2, 6-3 are respectively mounted on the first inverter circuit mounting substrate 41-1, the second inverter circuit mounting substrate 41-2, and the third inverter circuit mounting substrate 41-3, which are by-phase inverter mounting substrates configured as separate bodies, so that when the electronic component configuring one inverter circuit mounting substrate of the first inverter circuit mounting substrate 41-1, the second inverter circuit mounting substrate 41-2, and the third inverter circuit mounting substrate 41-3 fails, the maintenance task can be realized and the maintenance cost can be reduced by simply changing the inverter circuit mounting substrate that mounts the failed electronic component to a new one, the electronic component that is not yet failed is prevented from being discarded by minimizing the exchange range with a new electronic component thereby contributing to protection of global environment.

In the above configuration, the DC/DC converter circuit switching element group 11A configuring the DC/DC converter circuit 30 and the inverter circuit switching element group 12A configuring each of the by-phase inverter circuits 6-1, 6-2, 6-3 are arranged in parallel on a line on the DC/DC converter circuit mounting substrate 31 and the first to third inverter circuit mounting substrates 41-1, 41-2, 41-3, and furthermore, the DC/DC converter circuit switching element group 11A and the first inverter circuit switching element group 12A-1 are arranged to each other on the base member 5 in the case 1, the second inverter circuit switching element group 12A-2 and the third inverter circuit switching element group 12A-3 are arranged to face each other, and the first inverter circuit switching element group 12A-1 and the DC/DC converter circuit switching element group 11A, and the second inverter circuit switching element group 12-2 and the third inverter circuit switching element group 12A-3 are arranged to face each other on the base member 5 in the case, and hence each inverter circuit switching element group 12A-1 to 12A-3 and the DC/DC converter circuit switching element group are collected in a cluster on the base member 5 in the case 1 and the high heat generated in each switching element 11, 12 can be efficiently cooled so as not to affect other electronic components.

In the above configuration, the reactor 14 is arranged in the space 13 formed between the DC/DC converter circuit switching element group 11A and the first inverter circuit switching element group 2A-1, and the second inverter circuit switching element group 12A-2 and the third inverter circuit switching element group 12A-3 on the surface of the base member 5, so that the reactor 14 reduces the influence from the high heat generated by each switching element 11, 12 enabling them to be individually cooled, and the cooling function of the device can be efficiently achieved.

Furthermore, each one side of the first and second main heat sinks 16 is extended to the space 13 side to integrally form the air cooling fin 16A for cooling the reactor, and thus the reactor 14 can be cooled and the cooling function of each switching element 11,12 by the cooling fan 19 can be efficiently exhibited.

In the above configuration, the main heat sink 16 configuring the first main heat sink is installed so that the DC/DC converter circuit switching element group 11A and the second inverter circuit switching element group 12A-2 face each other, and the main heat sink 16 configuring the second main heat sink is installed so that the first inverter circuit switching element group 12A-1 and the third inverter circuit switching element group 12A-3 face each other on the rear surface side of the base member 5, so that the DC/DC converter circuit switching element group 11A and the first inverter circuit switching element group 12A-1, and the second inverter circuit switching element group 12A-2 and the third inverter circuit switching element group 12A-3 are individually cooled by the first and second main heat sinks 16, and consequently, an efficient cooling function can be exhibited.

In the above configuration, the auxiliary heat sinks 8A, 8B are respectively joined and installed so as to face each of switching element groups 12A-1 to 12A-3 and 11 A at the opposing substrate surface on the opposite side with respect to the substrate surface mounted with each of switching element groups 12A-1 to 12A-3 and 11A in the first to third inverter circuit mounting substrates 41-1, 41-2, 41-3 and the DC/DC converter circuit mounting substrate 31, and each auxiliary heat sink 8A, 8B is fitted to the through-hole 5A formed in the base member 5 to be directly joined to each main heat sink 16 thereby enhancing the cooling effect of each of switching element groups 12A-1 to 12A-3 and 11A.

In the above described configuration, the air cooling ducts end 17 are installed to face each auxiliary heat sink 8A, 8B at the rear surface side of the first and second main heat sinks 16, 16 to forcibly supply the cooling air into the air cooling ducts 17, 17 from the cooling fan 19m so that the first and second main heat sinks 16, 16 are individually cooled using the cold air introduced by each cooling fan 19 to the individual air cooling duct 17, 17, and each of switching element groups 11A_{,} 12A-1 to 12A-3 is efficiently cooled without being influenced by the high heat emitted from each other thereby efficiently exhibiting the cooling effect by each cooling fan.

In the above described configuration, each one side of the first and second main heat sink 16 is extended to the space side to form the reactor cooling air cooling fin 16A for cooling the reactor 14, where the cooling function of each of switching element groups 11A, 12A-1 to 12A-3 by the cooling fan 19 can be efficiently exhibited since the reactor 14 can be cooled by the reactor cooling air cooling fin 16A.

In the above configuration, the cooling fan 19 for forcibly supplying the cooling air to each of the air cooling ducts 17 is installed on the most upstream side of each of the air cooling ducts 17, and thus the cooling fan 19 can reduce the influence of the high heat generated by each of switching element groups 12A-1 to12A-3 and 11A and the lifespan of the cooling fan can be extended.

The cooling function can be enhanced by preventing the cold air from escaping from the air cooling duct 17 and the space 13 by arranging the rear surface lid body 1b on the housing 1a.

Furthermore, the CPU 22 that is subjected to heat is installed on the CPU mounting substrate 23 so as to be positioned on the upstream side of the air cooling duct 17 in the base member 5 to constantly exhibit the normal control function without being influenced by the high heat emitted by each of switching element groups 11A, 12A-1 to 12A-3 and the reactor 14.

In the above example, the power conditioner device for outputting a three-phase alternating current has been configured, but the present invention is not limited thereto and a power conditioner device for outputting a one-phase alternating current with the DC/DC converter circuit and a single inverter circuit, or a power conditioner device for outputting a single-phase alternating current with the DC/DC converter circuit and two inverter circuits may be configured.

As described above, the present invention has the DC/DC converter circuit and the inverter circuit mounted on the DC/DC converter circuit mounting substrate and the inverter circuit mounting substrate, which are configured as separate bodies, for modularization, so that the DC/DC converter circuit and the inverter circuit are mounted on the DC/DC converter circuit mounting substrate and the inverter circuit mounting substrate, which are configured as separate bodies, whereby when the individual electronic component fails, the maintenance task can be realized by simply changing the circuit mounting substrate mounted with one circuit to a new one and the maintenance cost can be reduced by continuously using the other circuit mounting substrate thereby minimizing the change range with the new electronic component and contributing to the protection of a global environment. The present invention is suitable to a power conditioner device that raises the DC power supplied from the solar cell, the fuel cell, and the like, converts the same to the alternating current, and supplies the alternating current power to a general load, and a module substrate structure used in the device.

## Claims

1. A power conditioner device for raising a DC power by a DC/DC converter circuit (30) and then converting to an AC power by an inverter circuit (40), and being configured by accommodating an electronic circuit such as the DC/DC converter circuit (30) and the inverter circuit (40) or a CPU (22) for controlling the operation of the circuits in a case body, **characterized in that** the DC/DC converter circuit (30) and the inverter circuit (40) are respectively mounted on a DC/DC converter circuit mounting substrate (31) and an inverter circuit (40) mounting substrate (41-1, 41-2, 41-3), which are configured as separate bodies, for modularization.

2. The power conditioner device according to claim 1, **characterized in that** the inverter circuit (40) is configured with two by-phase inverter circuits (6-1, 6-2, 6-3) to output a single-phase AC, and each of the by-phase inverter circuits (6-1, 6-2, 6-3) is mounted on each of by-phase inverter circuit (6-1, 6-2, 6-3) mounting substrates configured as a separate body for modularization.

3. The power conditioner device according to claim 1, **characterized in that** the inverter circuit (40) is configured with three by-phase inverter circuits (6-1, 6-2, 6-3) to output a three-phase AC, and each of the by-phase inverter circuits (6-1, 6-2, 6-3) is mounted on each of by-phase inverter circuit (6-1, 6-2, 6-3) mounting substrates configured as a separate body for modularization.

4. The power conditioner device according to claim 3, **characterized in that**
a plurality of inverter circuit switching elements (12) is mounted in parallel on each of the by-phase inverter circuit (6-1, 6-2, 6-3) mounting substrates to respectively configure each of the by-phase inverter circuits (6-1, 6-2, 6-3) to configure an inverter circuit switching element group (12A), and a plurality of DC/DC converter circuit switching element (11) configuring the DC/DC converter circuit (30) is mounted in parallel on the DC/DC converter circuit mounting substrate (31) to configure a DC/DC circuit switching element group;
a DC/DC converter circuit switching element group (11A) of the DC/DC converter circuit (30) and a first inverter circuit switching element group (12A) configuring a first by-phase inverter circuit (6-1, 6-2, 6-3) of the three by-phase inverter circuits (6-1, 6-2, 6-3) are arranged to face each other, and a second inverter circuit switching element, group (12A) configuring a second by-phase inverter circuit (6-1, 6-2, 6-3) and a third inverter circuit switching element group (112A) configuring a third by-phase inverter circuit (6-1, 6-2, 6-3) of the three by-phase inverter circuits (6-1, 6-2, 6-3) are arranged to face each other in the case; and
the DC/DC converter circuit switching element group (11A) and the first inverter circuit switching element group (12A), and the second inverter circuit switching elements group (12A) and the third inverter circuit switching element group (12A) are arranged to face each other in the case.

5. The power conditioner device according to claim 4, **characterized in that** the DC/DC converter circuit switching element group (11A) and the first inverter circuit switching element group (12A), and the second inverter circuit switching element group (12A) and the third inverter circuit switching element group (12A) are spaced apart from each other on a surface side of the base member (5) to form a space (13), a reactor (14) being arranged on the surface side of the base member (5) in the space (13).

6. The power conditioner device according to claim 5, **characterized in that** a first main heat sink (16) is installed on a rear surface side of the base member (5) so that the DC/DC converter circuit switching element group (11A) and the first inverter circuit switching element group (12A) face each other, and a second main heat sink (16) is installed so that the second inverter circuit switching element group (12A) and the third inverter circuit switching element group (12A) face each other.

7. A module substrate structure used in a power conditioner for raising a DC power by a DC/DC converter circuit (30) and then converting to an AC power by an inverter circuit (40), and being configured by accommodating an electronic circuit such as the DC/DC converter circuit (30) and the inverter circuit (40) or a CPU (22) for controlling the operation of the circuits in a case body, **characterized in that** the DC/DC converter circuit (30) and the inverter circuit (40) are respectively mounted on a DC/DC converter circuit mounting substrate (31) and an inverter circuit (40) mounting substrate (41-1, 41-2, 41-3), which are configured as separate bodies, for modularization.

8. The module substrate structure used in the power conditioner device according to claim 7, **characterized in that** the inverter circuit (40) is configured with two by-phase inverter circuits (6-1, 6-2, 6-3) to output a single-phase AC, and each of the by-phase inverter circuits (6-1, 6-2, 6-3) is mounted on each of by-phase inverter circuit (6-1, 6-2, 6-3) mounting substrates configured as a separate body for modularization.

9. The module substrate structure used in the power conditioner device according to claim 7, **characterized in that** the inverter circuit (40) is configured with three by-phase inverter circuits (6-1, 6-2, 6-3) to output a three-phase AC, and each of by-phase inverter circuits (6-1, 6-2, 6-3) is mounted on each of by-phase inverter circuit (6-1, 6-2, 6-3) mounting substrates configured as a separate body for modularization.
